# FASCICULE DE BREVET EUROPEEN

(11) **EP 4 191 878 B1**
(45) Date de publication et mention de la délivrance du brevet: **29.04.2026**
(21) Numéro de dépôt: 22211304.5
(22) Date de dépôt: 05.12.2022
(51) Int. Cl.: H03H 3/02, H03H 9/13, H03H 9/17

(54) **DISPOSITIF À ONDE ACOUSTIQUE DE VOLUME ET PROCÉDÉ DE RÉALISATION D'UN TEL DISPOSITIF**
VOLUMENSCHALLWELLENVORRICHTUNG UND VERFAHREN ZUR HERSTELLUNG SOLCH EINER VORRICHTUNG
BULK ACOUSTIC WAVE DEVICE AND METHOD FOR MANUFACTURING SUCH A DEVICE

(30) Priorité: 06.12.2021 FR 2113020
(43) Date de publication de la demande: 07.06.2023
(73) Titulaire: Commissariat à l'Energie Atomique et aux Energies Alternatives, 75015 Paris (FR)
(72) Inventeur: DUPONT, Florian, 38054 Grenoble Cedex 09 (FR); RODRIGUEZ, Guillaume, 38054 Grenoble Cedex 09 (FR)
(74) Mandataire: Hautier IP

(56) Documents cités:
- WO-A1-2018/063358
- WO-A1-2018/111532
- WO-A2-2018/004668
- CN-A- 111 769 809
- US-A1- 2019 273 480
- LANSIAUX X ET AL: "LiNbO3 thick films grown on sapphire by using a multistep sputtering process", JOURNAL OF APPLIED PHYSICS, vol. 90, no. 10, November 2001 (2001-11-01), pages 5274 - 5277, XP012053579

## Description

### DOMAINE TECHNIQUE

La présente invention concerne, en général, un dispositif à onde acoustique de volume, et plus particulièrement, un procédé de réalisation de la couche à base d'un matériau piézoélectrique formant le cœur de ce dispositif.

### ETAT DE LA TECHNIQUE

Les résonateurs basés sur une structure de type « onde acoustique de volume» dite BAW (acronyme de « Bulk Acoustic Wave ») sont couramment utilisés pour réaliser des filtres RF. Le cœur des résonateurs BAW est composé d'un matériau piézoélectrique qui influence les propriétés finales du filtre.

Le niobate de lithium (LiNbO3) est utilisé depuis plusieurs années en tant que matériau piézoélectrique. Ses propriétés intrinsèques, comme son coefficient de couplage piézoélectrique, pourrait permettre au filtre de résonner à haute fréquence, par exemple à des fréquences supérieures à 3,5 GHz, avec une bande passante pouvant aller jusqu'à 600MHz. Pour obtenir un filtre BAW présentant un coefficient de couplage élevé, typiquement jusqu'à 50%, la couche piézoélectrique à base de LiNbO3 doit notamment présenter une haute qualité cristalline et une stœchiométrie contrôlée.

Le document « A. Reinhardt et al., Acoustic filters based on thin single crystal LiNbO3 films: Status and prospects Proc. - IEEE Ultrason. Symp. 2014, 773 » divulgue une solution basée sur un procédé de report connu sous la dénomination Smart-Cut^{™} permettant de fabriquer un filtre BAW comprenant une couche piézoélectrique à base de LiNbO3 sur substrat silicium. Une couche mince de LiNbO3 est prélevée d'un substrat donneur, typiquement à partir d'un substrat de LiNbO3 monocristallin, puis reportée vers un substrat receveur, typiquement un substrat de silicium. Cette solution met en œuvre de nombreuses étapes techniques et présente un coût significatif.

Une autre solution consiste à synthétiser la couche piézoélectrique à base de LiNbO3 sur le substrat silicium, par l'intermédiaire d'une couche tampon. Le document « Growth of highly near-c-axis oriented ferroelectric LiNbO3 thin films on Si with a ZnO buffer layer, P. You et al., Appl. Phys. Lett. 2013, 102, 051914 » propose de former une couche tampon à base d'oxyde de zinc sur le substrat silicium, avant de former la couche à base de niobate de lithium sur cette couche tampon. La couche piézoélectrique à base de LiNbO3 ainsi synthétisée présente néanmoins une texturation. Elle n'est pas monocristalline. La couche tampon à base de ZnO n'est pas non plus totalement compatible avec une intégration au sein d'un dispositif fonctionnel, notamment avec certaines étapes de gravure telle qu'une gravure de l'électrode inférieure ou une gravure pour la formation de la cavité sous le ZnO. Des problèmes d'adhérence sont également observés.

Le document CN111769809A divulgue un procédé de fabrication d'un filtre BAW FBAR qui supprime la planarisation CMP avant formation de la membrane du dispositif.

Il existe donc un besoin consistant à réaliser un dispositif électro-acoustique comprenant une couche piézoélectrique à base de niobate de lithium sur un substrat à base de silicium, qui présente une qualité améliorée, tout en limitant les coûts de réalisation.

Un objectif de la présente invention est de répondre au moins en partie à ce besoin.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un dispositif électro-acoustique comprenant une couche piézoélectrique, selon la revendication 1 de la présente invention. Le procédé comprend notamment les étapes suivantes :
- Fournir un substrat à base de silicium,
- Former une première électrode sur le substrat,
- Former la couche piézoélectrique sur la première électrode,
- Former une deuxième électrode sur la couche piézoélectrique.

La formation de la couche piézoélectrique se fait par épitaxie, sur ladite première électrode, d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta).

La première électrode est choisie en un matériau réfractaire conducteur électrique à base de nitrure, avantageusement tel que TiN, VN, ZrN, TaN, HfN, NbN, ou un alliage desdits matériaux.

De façon préférée, le matériau ABO3 de la couche piézoélectrique est pris parmi le niobate de lithium LiNbO3, le tantalate de lithium LiTaO3, ou un alliage Li(Nb, Ta)O3.

Dans le cadre du développement de la présente invention, certaines conditions pour la croissance par épitaxie de la couche piézoélectrique ont été déterminées. La première électrode doit de préférence présenter au moins certaines des propriétés suivantes :
- Avoir une structure cristalline et/ou un paramètre de maille compatible avec un substrat à base de silicium. Cela permet par exemple d'épitaxier la première électrode sur le substrat.
- Avoir une structure cristalline et/ou un paramètre de maille proche ou compatible avec le niobate de lithium ou le tantalate de lithium. Cela permet d'épitaxier la couche piézoélectrique sur la première électrode, qui forme ainsi une couche de nucléation.
- Avoir un coefficient de dilatation thermique proche du niobate de lithium ou du tantalate de lithium. Cela permet de limiter l'apparition de fissures due aux variations de températures lors de la formation de la couche piézoélectrique.
- Etre électriquement conductrice.
- Pouvoir bloquer la diffusion des atomes de Li dans le Si. Cela permet d'éviter une perte de stoechiométrie d'une couche piézoélectrique à base de niobate de lithium ou de tantalate de lithium, dite couche LN/LT.
- Confiner une onde acoustique, notamment en vue de garantir de hautes performances pour les dispositifs électro-acoustiques.

Un préjugé technique de l'état de la technique est que la couche de nucléation doit nécessairement être à base d'oxyde afin d'éviter une perte de stoechiométrie de la couche LN/LT due à une diffusion de l'oxygène depuis la couche LN/LT vers la couche de nucléation.

Au contraire, pour répondre à ce cahier des charges, la première électrode formant la couche de nucléation est choisie selon la présente invention en un matériau réfractaire conducteur électrique à base de nitrure. Ce matériau est typiquement un nitrure réfractaire de transition à base d'un métal de transition, par exemple TiN, VN, ZrN, TaN, HfN, NbN, ou leurs alliages. Dans le cadre du développement de la présente invention, il a en effet été observé qu'une telle couche de nucléation permet, de manière parfaitement inattendue, l'épitaxie de la couche LN/LT dans de bonnes conditions. De façon surprenante, il a été également observé qu'une telle couche de nucléation permet de bloquer à la fois la diffusion d'oxygène et la diffusion du lithium vers le substrat à base de silicium. Il en résulte que la couche LN/LT épitaxiée sur une telle couche de nucléation conserve la stoechiométrie requise.

Par ailleurs, les différentes structures cristallines et les paramètres de maille des nitrures réfractaires de transition sont parfaitement compatibles avec celles et ceux des matériaux LN/LT et du silicium. Une telle couche de nucléation peut donc avantageusement être épitaxiée sur un substrat à base de silicium, puis permettre l'épitaxie de la couche LN/LT.

Par ailleurs, les nitrures réfractaires de transition sont conducteurs et peuvent donc être utilisés comme première électrode d'un filtre BAW. Si ces matériaux sont épitaxiés sur silicium, ils peuvent présenter des valeurs de résistivités de l'ordre de 15µOhm.cm, ce qui est parfaitement compatible avec la fabrication d'un filtre BAW.

Par ailleurs, les nitrures réfractaires de transition sont résistants aux conditions de croissance du LiNbO3, en particulier la température élevée requise pour la croissance du LiNbO3, qui peut être de l'ordre 1000°C.

Par ailleurs, les nitrures réfractaires de transition sont suffisamment durs pour protéger la surface du silicium lors de la croissance du LiNbO3. Ils protègent par exemple le silicium du plasma et de l'impact des ions utilisés dans la mise en œuvre d'une technique de dépôt physique en phase vapeur PVD pour la croissance du LiNbO3.

Les nitrures réfractaires de transition peuvent également présenter des valeurs de rigidité et d'impédance acoustique intéressantes pour confiner davantage les ondes acoustiques dans la couche piézoélectrique.

La présente invention propose ainsi une solution permettant de former un dispositif électro-acoustique sur un substrat à base de silicium - sans étape de report - par l'intermédiaire de la première électrode à base d'un nitrure réfractaire de transition, jouant le rôle de couche de nucléation. Grâce à une telle couche de nucléation en un matériau réfractaire conducteur électrique à base de nitrure, la couche piézoélectrique LN/LT est stoechiométrique et de haute qualité cristalline.

La couche piézoélectrique présente ainsi les propriétés requises pour une application de type filtre BAW haute fréquence.

Selon un autre aspect de l'invention, on prévoit un dispositif électro-acoustique selon la revendication 6 de la présente invention, notamment un dispositif à onde acoustique de volume (BAW), comprenant notamment, en empilement selon une direction verticale :
- un substrat à base de silicium,
- une première électrode sur ledit substrat,
- une couche piézoélectrique sur ladite première électrode, ladite couche piézoélectrique étant à base d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta),
- une deuxième électrode disposée sur la couche piézoélectrique.

La première électrode du dispositif BAW est en un matériau réfractaire conducteur électrique à base de nitrure. De façon préférée, la couche piézoélectrique est à base de niobate de lithium LiNbO3, ou de tantalate de lithium LiTaO3, ou d'un alliage Li(Nb, Ta)O3. Les avantages mentionnés ci-dessus s'appliquent *mutatis mutandis.* Un tel dispositif est en outre directement intégrable en technologie silicium. Il peut être facilement co-intégré avec d'autres dispositifs microélectroniques ou optoélectroniques ou encore avec des microsystèmes (opto-) électromécaniques (MEMS ou MOEMS, acronymes respectifs de « Microelectromechanical systems » et « Microoptoelectromechanical systems »).

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre en coupe transverse un dispositif électro-acoustique de type BAW selon un exemple utile pour comprendre la présente invention.
La figure 2 illustre en coupe transverse un dispositif électro-acoustique de type BAW FBAR selon un exemple utile pour comprendre la présente invention.
La figure 3A illustre en coupe transverse un dispositif électro-acoustique de type BAW SMR selon un mode de réalisation la présente invention.
La figure 3B illustre en coupe transverse un dispositif électro-acoustique de type BAW SMR selon un autre mode de réalisation la présente invention.
Les figures 4A à 4E illustrent des étapes d'un procédé de fabrication d'un dispositif électro-acoustique de type BAW FBAR selon un exemple utile pour comprendre la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le matériau réfractaire conducteur électrique à base de nitrure de la première électrode est choisi de façon à présenter ou à former :
- Une résistance à l'oxydation,
- Une barrière à la diffusion du lithium.

Cela permet d'éviter une diffusion de l'oxygène et du lithium depuis la couche piézoélectrique LN/LT vers la première électrode. La stœchiométrie de la couche LN/LT est ainsi préservée.

Selon un exemple, le matériau réfractaire conducteur électrique à base de nitrure de la première électrode est choisi de façon à présenter une dureté ou une rigidité mécanique suffisamment élevée pour permettre de confiner une onde acoustique dans la couche piézoélectrique LN/LT. Par exemple, le module d'Young de ce matériau est supérieur à 300 GPa. Sa dureté ou résistance peut être supérieure à 9000 MPa.

Selon un exemple, le matériau réfractaire conducteur électrique à base de nitrure de la première électrode est choisi de façon à présenter une structure cristallographique compatible avec le substrat et la couche piézoélectrique LN/LT, telle qu'une structure hexagonale ou cubique face centrée. Cela permet de limiter l'apparition de défauts structuraux lors de la formation de la couche LN/LT par épitaxie.

Selon un exemple, la formation de la première électrode est configurée de sorte que ladite première électrode présente une épaisseur e2 comprise entre 10 nm et 1000 nm, par exemple 100 nm. Cela permet d'obtenir la qualité cristalline souhaitée et/ou de limiter l'apparition de défauts structuraux.

Selon un exemple, la formation de la couche piézoélectrique LN/LT est configurée de sorte que ladite couche LN/LT présente, après épitaxie, une épaisseur e3 comprise entre plusieurs centaines de nanomètres et plusieurs microns. Une telle épaisseur e3 permet d'obtenir la fréquence de résonnance voulue pour le filtre BAW.

Selon un exemple, le matériau réfractaire conducteur électrique à base de nitrure est pris parmi les nitrures réfractaires de transition à base d'un métal de transition tel que du nitrure de titane TiN, du nitrure de tantale TaN, du nitrure de Niobium NbN, du nitrure de zirconium ZrN, du nitrure d'hafnium HfN, du nitrure de vanadium VN, ou leurs alliages.

Selon un exemple, le matériau réfractaire conducteur électrique à base de nitrure de la première électrode est choisi parmi un nitrure réfractaire de transition tel que du nitrure de titane TiN, du nitrure de tantale TaN, du nitrure de Niobium NbN, du nitrure de zirconium ZrN, du nitrure d'hafnium HfN, du nitrure de vanadium VN, ou leurs alliages.

Selon un exemple, le dispositif électro-acoustique est un filtre à ondes acoustiques de volume du type à membrane suspendue. Selon un exemple, le procédé comprend, après formation par épitaxie de la couche piézoélectrique, une gravure du substrat à base de silicium sous la première électrode portant la couche piézoélectrique, de façon à former une cavité.

Selon l'invention, le dispositif électro-acoustique est un filtre à ondes acoustiques de volume guidées sur réflecteur de Bragg. Selon l'invention, le procédé comprend, avant formation de la première électrode, une formation d'un empilement de couches alternées des impédances acoustiques fortes et faibles.

Les couches de faible impédance sont à base de TiN ou de VN, et les couches de forte impédance sont à base de HfN ou de TaN.

Selon un exemple, la formation de la première électrode et/ou la formation de la couche piézoélectrique LN/LT sont effectuées par ablation laser pulsée.

Selon un exemple, la formation de la première électrode et la formation de la couche piézoélectrique LN/LT sont effectuées par ablation laser pulsée successivement au sein d'un même réacteur sans remise à l'air entre lesdites formations. Cela permet d'éviter une étape de nettoyage de surface intermédiaire, de réduire la durée totale du procédé et de limiter les coûts. Cela permet également d'obtenir une faible rugosité en surface de la couche LN/LT.

Selon un exemple, le substrat est à base de silicium orienté selon (111), la première électrode est à base de nitrure de titane TiN orienté selon (111), et la couche piézoélectrique est orientée selon (0001).

Selon un exemple, la couche piézoélectrique LN/LT est directement au contact de la première électrode. En particulier, il n'y a pas de couche d'oxyde intercalaire entre la première électrode et la couche LN/LT.

Selon un exemple, le matériau réfractaire conducteur électrique à base de nitrure de la première électrode est un nitrure réfractaire de transition tel que du nitrure de titane TiN, du nitrure de tantale TaN, du nitrure de Niobium NbN, du nitrure de zirconium ZrN, du nitrure d'hafnium HfN, du nitrure de vanadium VN, ou leurs alliages.

Selon un exemple, le dispositif électro-acoustique est un filtre à ondes acoustiques de volume du type à membrane suspendue, comprenant une cavité sous la première électrode portant la couche piézoélectrique.

Selon l'invention le dispositif électro-acoustique est un filtre à ondes acoustiques de volume guidées sur réflecteur de Bragg, comprenant, entre le substrat et la première électrode, un empilement de couches alternées présentant des impédances acoustiques fortes et faibles.

Selon un exemple, les première et deuxième électrodes sont contactées au niveau d'une face avant du dispositif.

Selon un exemple, la première électrode est contactée au niveau d'une face arrière du dispositif, et la deuxième électrode est contactée au niveau d'une face avant du dispositif.

Selon un exemple, le substrat à base de silicium est formé d'un matériau pris parmi : le silicium, le SiC, le SiGe.

Selon un exemple, le substrat à base de silicium est monocristallin.

Selon un exemple alternatif, le substrat à base de silicium est polycristallin.

Selon un exemple, le substrat à base de silicium est orienté selon (111).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si, Si dopé, SiC, SiGe. Une couche à base de TiN s'entend par exemple d'une couche TiN, TiN dopée, ou des alliages de TiN.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

On entend par « conducteur électrique » un matériau présentant une valeur de résistivité inférieure à 10000 µOhm.cm, de préférence inférieure à 300 µOhm.cm, et encore préférentiellement inférieure à 100µOhm.cm, notamment pour un conducteur électrique formé par une électrode inférieure.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, un nitrure réfractaire de transition est un nitrure d'un métal de transition ou élément de transition (élément dont les atomes ont une sous-couche électronique d incomplète, ou qui peuvent former des cations dont la sous-couche électronique d est incomplète). Ces éléments sont regroupés au sein du bloc d du tableau périodique des éléments.

Dans les exemples décrits ci-dessous, la couche LN/LT illustrée est à base de niobate de lithium LiNbO3. Une couche de tantalate de lithium LiTaO3 ou une couche à base d'un alliage Li(Nb,Ta)O3 peut être substituée à cette couche de niobate de lithium LiNbO3 dans le cadre de cette invention. Ainsi, toutes les caractéristiques et tous les effets techniques mentionnés à propos du LiNbO3 sont parfaitement applicables et combinables à une couche de LiTaO3 ou de Li(Nb,Ta)O3.

Des analyses en diffraction des rayons X, par exemple en configuration 2θ, ou en rotation selon φ et/ou Ω (phi-scan et omega-scan), peuvent être effectuées de manière à déterminer la qualité cristalline des couches LN/LT et des électrodes ou couches de nucléation, et leur relation d'épitaxie.

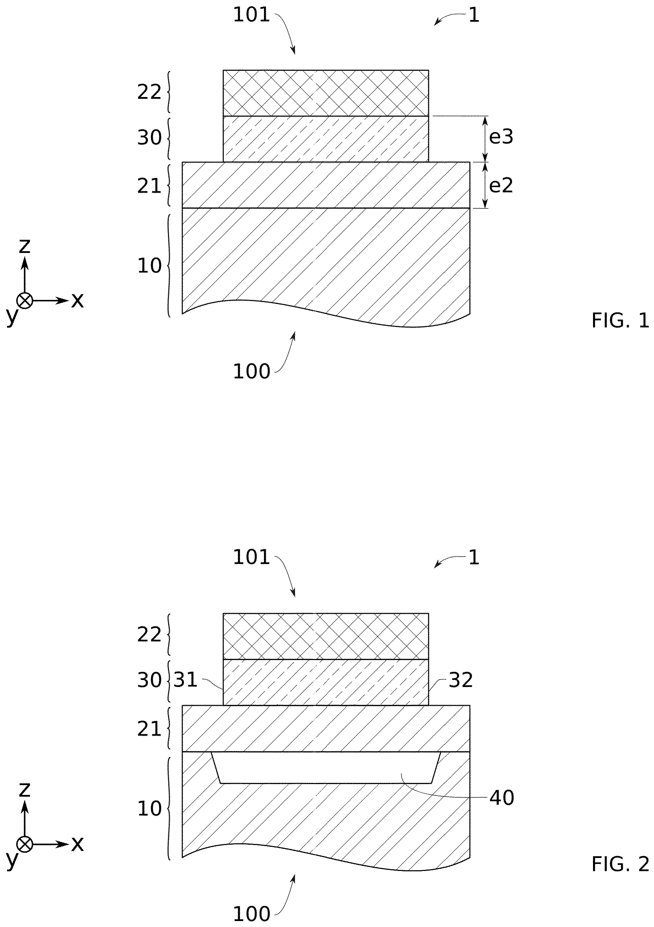

La figure 1 illustre en coupe transverse un dispositif 1 de type filtre BAW HBAR, selon un exemple utile pour comprendre l'invention. Ce dispositif 1 comprend typiquement un substrat 10 à base de silicium sur lequel est formée une première électrode 21 à base de nitrure de titane TiN. Une couche 30 de niobate de lithium LiNbO3 est directement au contact de la première électrode 21. Une deuxième électrode 22 surmonte la couche 30 piézoélectrique LN/LT.

L'utilisation d'une première électrode à base de nitrure réfractaire conducteur électrique, notamment en TiN, permet avantageusement de réaliser une hétéro-épitaxie de LiNbO3 sur substrat 10 silicium. Cette première électrode 21 peut ainsi être assimilée à une couche de nucléation. Cette solution permet de réaliser des dispositifs 1 électroacoustiques BAW de haute performance. L'épitaxie permet notamment d'obtenir une couche de LiNbO3 stoechiométrique, orientée préférentiellement selon une unique orientation cristalline dans toutes les directions et de haute qualité cristalline. L'épaisseur de cette couche de LiNbO3 obtenue par épitaxie est en outre parfaitement contrôlée. La couche de LiNbO3 peut être formée directement sur des substrats 10 de différentes tailles, sans étape de report intermédiaire. Cela permet avantageusement de diminuer les coûts de fabrication d'un tel empilement de couches 10, 21, 30. Un tel procédé peut en outre être directement intégré dans une usine de production au standard de la technologie CMOS (transistors MOS - Métal/Oxyde/Semiconducteur - complémentaires de type N et P).

Le substrat 10 peut être un substrat massif de silicium, dit bulk. Alternativement ce substrat 10 peut être un substrat de type SOI (acronyme de « Silicon On Insulator » signifiant silicium sur isolant). D'autres substrats 10 peuvent être envisagés, par exemple des substrats à base de SiC. De tels substrats présentent une compatibilité totale avec les technologies silicium pour la micro-électronique. Le silicium peut être également conducteur thermique et/ou électrique. Cela permet par exemple d'évacuer la chaleur générée dans un filtre BAW en fonctionnement. Cela permet éventuellement de contacter le dispositif par la face arrière 100, notamment lorsque le silicium est dopé.

La première électrode ou couche de nucléation 21 est de préférence à base d'un nitrure réfractaire de transition. Elle présente de préférence une structure cristallographique hexagonale ou cubique face centrée. Une telle structure permet notamment une épitaxie de la couche de nucléation sur du silicium orienté selon (001) et (111). Cela permet également d'épitaxier un matériau LN/LT selon différentes orientations cristallines. De façon préférée, le silicium est orienté selon (111). La couche de nucléation 21 est par exemple à base de nitrure de titane TiN. Le TiN est typiquement conducteur thermique et électrique. Le TiN est en outre un matériau rigide permettant de confiner une onde acoustique dans une couche supérieure de type LN/LT. Le TiN peut être cru ou déposé sur silicium de façon connue. Le nitrure de vanadium, le nitrure de zirconium, le nitrure de tantale, le nitrure d'Hafnium et le nitrure de niobium présentent des propriétés similaires à celles du nitrure de titane. Ils peuvent également être avantageusement choisis en tant que première électrode / couche de nucléation 21. Dans la suite, du fait de sa double fonction d'électrode et de couche de nucléation, la première électrode 21 est dénommée « électrode de nucléation 21 ».

L'électrode de nucléation 21 peut être formée par une technique de dépôt physique ou chimique, par exemple et de façon préférée par ablation laser pulsé PLD (acronyme de « Pulsed Laser Deposition »). Elle peut être alternativement formée par l'une des techniques suivantes: dépôt chimique en phase vapeur (CVD, acronyme de chemical vapor deposition), préférentiellement dépôt chimique en phase vapeur à précurseurs métal-organiques (MOCVD, acronyme de metal organic chemical vapor deposition), pulvérisation cathodique PVD (sputtering), dépôt par couche atomique assistée par plasma (PEALD, acronyme de plasma enhanced atomic layer deposition).

Elle est de préférence épitaxiée sur le substrat 10. Cela permet d'obtenir une couche de nucléation 21 monocristalline. Selon un autre mode de réalisation, l'électrode de nucléation 21 est polycristalline avec par exemple une orientation préférentielle. Une orientation selon un plan de croissance (111) peut être typiquement choisie pour une électrode de nucléation 21 en TiN.

L'électrode de nucléation 21 formée sur le substrat 10 est de préférence stoechiométrique. Elle présente une épaisseur e2 comprise entre 10 et 1000 nanomètres, par exemple de l'ordre de 100 nm. L'épaisseur e2 de l'électrode de nucléation 21 peut être choisie en fonction de la qualité cristalline souhaitée.

La couche piézoélectrique 30 LN/LT est à base de niobate de lithium LiNbO3 ou de tantalate de lithium LiTaO3, ou encore un alliage du type Li(Ta,Nb)O3. Cette couche 30 peut être formée par une technique de dépôt physique ou chimique, par exemple et de façon préférée par ablation laser pulsée PLD. Elle peut être alternativement formée par l'une des techniques suivantes: dépôt chimique en phase vapeur (CVD, acronyme de chemical vapor deposition), préférentiellement dépôt chimique en phase vapeur à précurseurs métal-organiques (MOCVD, acronyme de metal organic chemical vapor deposition), pulvérisation cathodique PVD (sputtering), épitaxie par jet moléculaire (MBE, acronyme de Molecular Beam Epitaxy).

La couche piézoélectrique 30 LN/LT est avantageusement épitaxiée sur l'électrode de nucléation 21. Elle peut être monocristalline ou polycristalline, avec par exemple une orientation préférentielle. Une orientation selon un plan de croissance (0001) peut être typiquement choisie. Cela permet de maximiser la vitesse de propagation des ondes acoustiques au sein de la couche 30 LN/LT. D'autres orientations peuvent être choisies en fonction de l'application désirée.

La couche 30 LN/LT formée sur l'électrode de nucléation 21 est de préférence stoechiométrique, par exemple Li₁Nb₁O₃. Le pourcentage atomique de lithium est idéalement proche de 50 %. La couche 30 LN/LT présente une épaisseur e3 comprise entre 50 nanomètres et quelques centaines de nanomètres ou quelques microns, par exemple de l'ordre de 500 nm. L'épaisseur e3 de la couche 30 LN/LT peut être choisie en fonction de la fréquence de résonance souhaitée.

Selon une possibilité, l'électrode de nucléation 21 et la couche 30 LN/LT sont toutes deux réalisées *in situ* par PLD dans un même réacteur de croissance. La croissance de la couche 30 LN/LT peut ainsi être réalisée directement après la fin de croissance de l'électrode de nucléation 21. Cela permet d'éviter une remise à l'air de l'électrode de nucléation 21 avant épitaxie de la couche 30 LN/LT. La surface de l'électrode de nucléation 21 n'est donc pas contaminée, ni polluée, ni oxydée. Cela évite une étape de nettoyage intermédiaire. La durée du procédé est ainsi diminuée. Cela permet également de limiter l'apparition de rugosité lors de la formation de la couche 30 LN/LT. L'état de l'interface entre la couche 30 LN/LT et l'électrode de nucléation 21 n'est donc pas modifié et la surface de la couche 30 LN/LT est ainsi optimisée.

La deuxième électrode 22 est typiquement à base d'un matériau d'électrode électriquement conducteur. Selon une possibilité, ce matériau d'électrode peut également présenter une forte impédance acoustique. Le platine, l'aluminium ou le molybdène peuvent être choisis comme matériau d'électrode. La deuxième électrode 22 peut être structurée de façon à présenter des motifs d'électrode. Une telle électrode 22 est typiquement formée par lithographie/gravure à partir d'une couche électriquement conductrice déposée sur la couche 30 LN/LT. Dans les dispositifs électro-acoustiques 1 selon la présente invention, la couche piézoélectrique 30 est prise en sandwich entre les première et deuxième électrodes 21, 22, selon la direction verticale z. La couche piézoélectrique 30 est de préférence directement au contact des première et deuxième électrodes 21, 22.

La figure 2 illustre un autre mode de réalisation du dispositif 1. Dans cet exemple, le dispositif 1 est un filtre BAW de type FBAR. Les caractéristiques des différents éléments décrits ci-dessus dans le cas du BAW HBAR (substrat, électrode de nucléation, couche piézoélectrique, deuxième électrode) sont également valables dans les modes de réalisation qui suivent, *mutatis mutandis.* En plus des éléments décrits ci-dessus, le BAW FBAR comprend une cavité 40 formée dans le substrat 10, sous la couche piézoélectrique 30 et l'électrode de nucléation 21.

Cette cavité 40 peut être formée par gravure du substrat 10 au travers d'une ouverture de l'électrode de nucléation 21. Avantageusement, dans le cas d'un substrat silicium et d'une électrode de nucléation 21 en TiN, la sélectivité de gravure S_{Si}:S_{TiN} entre le Si et le TiN est suffisamment élevée, typiquement supérieure à 5:1, de façon à ce que l'électrode de nucléation 21 ne soit pas endommagée lors de la gravure du silicium. La gravure du silicium peut se faire en gravure humide à base d'une solution d'ammoniaque diluée NH4OH ou d'hydroxyde de tétraméthylammonium (TMAH). L'électrode de nucléation 21 forme dès lors, avec la couche piézoélectrique 30, une membrane suspendue au-dessus de la cavité 40.

La cavité 40 est de préférence formée à l'aplomb de la couche piézo-électrique 30. Elle peut s'étendre de part et d'autre des bords 31, 32 de la couche piézoélectrique 30, en projection dans le plan xy.

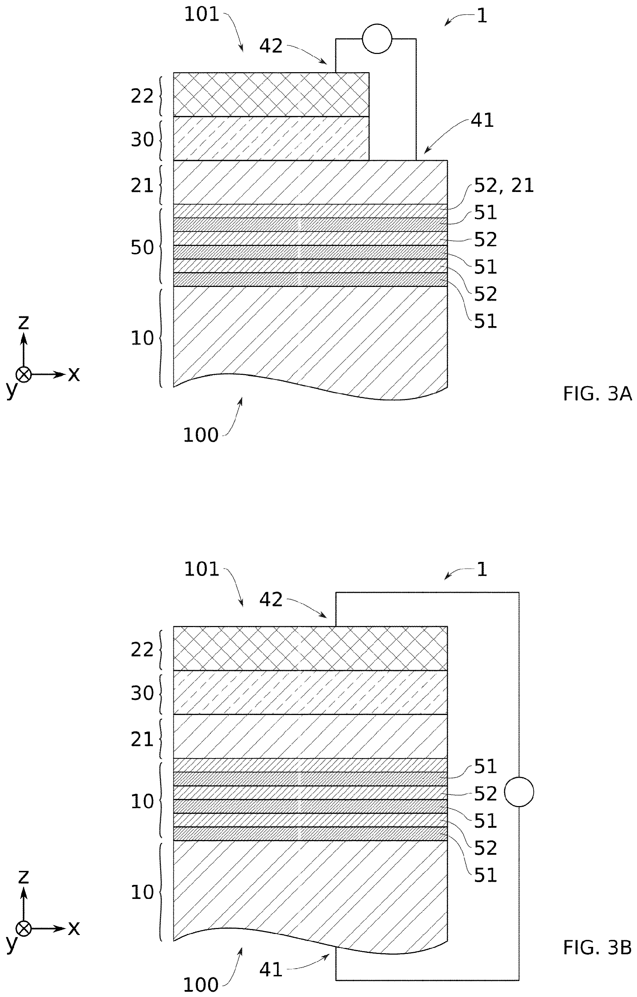

Les figures 3A, 3B illustrent différents modes de réalisation d'un dispositif 1 de type BAW-SMR selon l'invention. Dans ces dispositifs, en plus des éléments du BAW HBAR, un empilement 50 de couches 51, 52 formant un réflecteur de Bragg « acoustique » est intercalé entre le substrat 10 et l'électrode de nucléation 21.

Cet empilement 50 est de préférence épitaxié sur le substrat 10. Il présente de préférence une conduction électrique au travers de l'ensemble des couches 51, 52. Dans le mode de réalisation illustré à la figure 3A, les contacts électriques 41, 42 sont réalisés d'un même côté du dispositif 1, typiquement en face avant 101, directement sur les première et deuxième électrodes 21, 22. Dans le mode de réalisation illustré à la figure 3B, les contacts électriques 41, 42 sont réalisés sur deux côtés opposés du dispositif 1, typiquement en face avant 101 sur l'électrode 22 et en face arrière 100 du substrat 10. La première électrode 21 est alors indirectement contactée via le substrat 10 et l'empilement 50. Cela permet d'éviter une reprise de contact en face avant pour la première électrode 2, qui se trouve sous la couche piézo-électrique 30. Le nombre d'étapes du procédé est ainsi réduit. Cela permet avantageusement d'augmenter la surface exploitable de la couche piézoélectrique 30 en face avant, dans le plan xy.

Les couches 51, 52 sont respectivement des couches de forte impédance acoustique et de faible impédance acoustique, relativement les unes aux autres. On choisira typiquement un facteur supérieur à 2, et de préférence supérieur à 3, entre les valeurs de forte impédance acoustique et de faible impédance acoustique (unité Mrayl). Avantageusement, les couches 51, 52 peuvent être conductrices électriquement. Les couches de forte impédance acoustique sont à base de HfN ou de TaN. Les couches de faible impédance acoustique sont à base de TiN ou de VN. La dernière couche 52 de l'empilement 50 sous la couche piézoélectrique 30, par exemple en TiN, peut avantageusement former l'électrode de nucléation 21. Cela réduit encore le nombre d'étapes nécessaires à la fabrication du BAW-SMR.

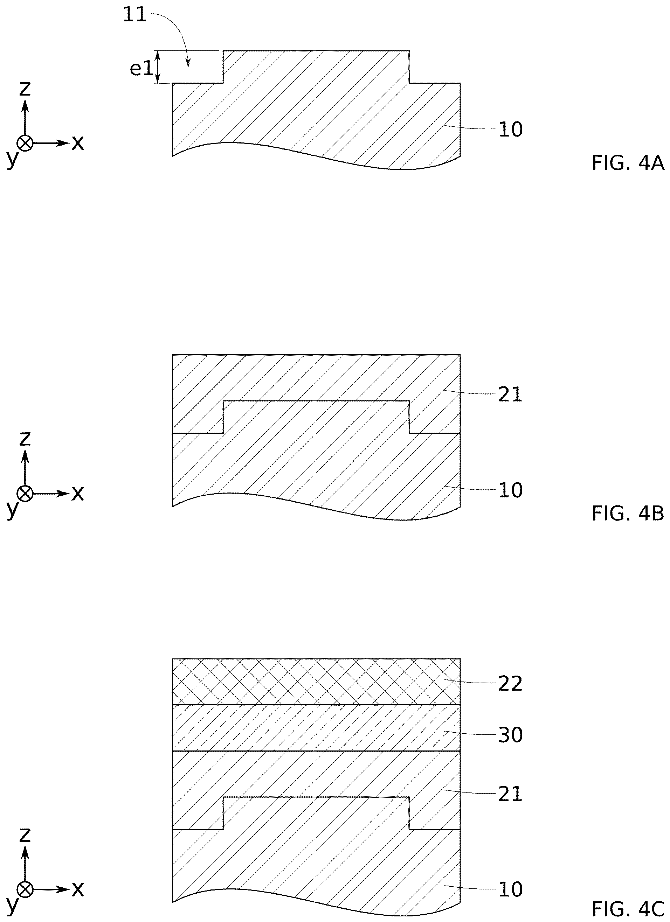

Les figures 4A à 4E illustrent des étapes d'un procédé de fabrication d'un BAW-FBAR, selon un exemple utile pour comprendre l'invention.

Comme illustré à la figure 4A, préalablement à la formation de l'électrode de nucléation 21, le substrat silicium 10 peut être structuré de façon à former une structure en mésa de hauteur e1, bordée par au moins un retrait de matière 11. La hauteur e1 de la structure en mésa peut être de l'ordre de quelques centaines de nanomètres à quelques microns, par exemple de l'ordre de 500 nm. Cette structuration se fait typiquement par lithographie/gravure conventionnelle.

Comme illustré à la figure 4B, l'électrode de nucléation 21 est formée, de préférence par épitaxie, sur et autour de la structure en mésa. Une étape de planarisation, typiquement par polissage mécano-chimique CMP, peut ensuite être effectuée.

Comme illustré à la figure 4C, la couche piézoélectrique 30 est ensuite épitaxiée sur l'électrode de nucléation 21, puis la deuxième électrode 22 est formée, par exemple par dépôt PVD, sur la couche piézoélectrique 30.

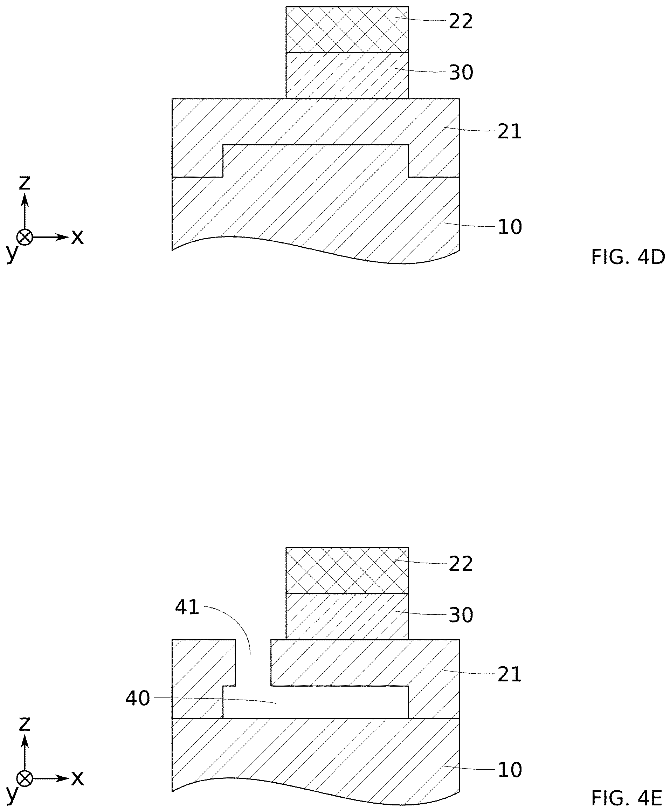

Comme illustré à la figure 4D, l'empilement des couches 30, 22 est structuré par lithographie/gravure de façon à présenter une dimension latérale l2 inférieure à la dimension latérale l1 de la structure en mésa sous-jacente. Avantageusement, l'électrode de nucléation 21 présente une résistance à la gravure suffisante pour obtenir un bon contrôle de l'arrêt de gravure lors de cette première gravure, en surface de l'électrode de nucléation 21. Selon un mode de réalisation, lorsque l'électrode de nucléation 21 est en TiN, elle forme une couche d'arrêt pour la gravure.

Comme illustré à la figure 4E, une deuxième gravure peut être effectuée pour former au moins une ouverture 41 dans l'électrode de nucléation 21, par exemple en bordure de l'empilement des couches 30, 22. Les couches 30, 22 sont typiquement protégées par le masque en résine encapsulant les couches 30, 22, lors de l'ouverture de l'électrode de nucléation 21. Une troisième gravure permet ensuite de former la cavité 40 sous l'empilement des couches 30, 22, 21. En particulier, la structure en mésa du substrat silicium est retirée au travers de l'ouverture 41 lors de cette troisième gravure. Il n'est pas nécessaire de refermer la cavité 40. L'ouverture 41 dans la couche 21 n'est pas nécessairement comblée ou rebouchée.

De façon préférée, la première gravure permet de graver la couche piézoélectrique 30 sélectivement vis-à-vis de l'électrode de nucléation 21. La troisième gravure permet de graver le substrat 10 sélectivement vis-à-vis de l'électrode de nucléation 21.

Un dispositif 1 BAW de type FBAR est ainsi avantageusement obtenu. La présente invention permet avantageusement de former des dispositifs électro-acoustiques comprenant une couche piézoélectrique LN/LT de bonne qualité cristalline sur des substrats à base de silicium, par l'intermédiaire d'une électrode de nucléation en un matériau réfractaire conducteur électrique à base de nitrure, typiquement à base de nitrure de transition. Ces dispositifs électro-acoustiques BAW sont avantageusement directement intégrables ou co-intégrables en technologie silicium. D'autres applications peuvent être envisagées.

## Revendications

1. Procédé de réalisation d'un dispositif électro-acoustique (1) comprenant une couche piézoélectrique (30), ledit dispositif électro-acoustique (1) étant un filtre à ondes acoustiques de volume guidées sur réflecteur de Bragg, ledit procédé comprenant les étapes suivantes :
• Fournir un substrat (10) à base de silicium,
• Former sur le substrat (10) une première électrode (21),
• Former la couche piézoélectrique (30) sur la première électrode (21),
• Former sur la couche piézoélectrique (30) une deuxième électrode (22),
dans lequel la première électrode (21) est choisie en un matériau réfractaire conducteur électrique à base de nitrure et dans lequel la formation de la couche piézoélectrique (30) se fait par épitaxie, sur ladite première électrode (21), d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta),
ledit procédé comprenant en outre, avant formation de la première électrode (21), une formation d'un empilement (50) de couches (51, 52) alternées présentant respectivement des impédances acoustiques fortes et faibles, les couches de faible impédance (52) étant à base de TiN ou de VN, et les couches de forte impédance (51) étant à base de HfN ou de TaN, l'empilement (50) formant un réflecteur de Bragg.

2. Procédé selon la revendication précédente dans lequel le matériau réfractaire conducteur électrique à base de nitrure est pris parmi les nitrures réfractaires de transition à base d'un métal de transition.

3. Procédé selon la revendication précédente dans lequel le matériau réfractaire conducteur électrique à base de nitrure est pris parmi TiN, VN, ZrN, TaN, HfN, NbN, ou leurs alliages.

4. Procédé selon l'une quelconque des revendications précédentes dans lequel la formation de la première électrode (21) et la formation de la couche piézoélectrique (30) sont effectuées par ablation laser pulsée successivement au sein d'un même réacteur sans remise à l'air entre lesdites formations.

5. Procédé selon l'une quelconque des revendications précédentes dans lequel le substrat (10) est à base de silicium orienté selon (111), la première électrode (21) est à base de nitrure de titane TiN orienté selon (111), et la couche piézoélectrique (30) est orientée selon (0001).

6. Dispositif (1) électro-acoustique comprenant, en empilement selon une direction dite verticale (z), un substrat (10) à base de silicium, une première électrode (21) sur ledit substrat (10), une couche piézoélectrique (30) sur ladite première électrode (21), ladite couche piézoélectrique (30) étant à base d'un matériau du type ABO3, O étant l'oxygène, A étant au moins un premier élément chimique pris parmi le sodium (Na), le potassium (K), le baryum (Ba), le lithium (Li), le plomb (Pb), et B étant au moins un deuxième élément chimique pris parmi le zirconium (Zr), le titane (Ti), le niobium (Nb), le tantale (Ta), une deuxième électrode (22) disposée sur la couche piézoélectrique (30), le dispositif (1) étant **caractérisé en ce que** la première électrode (21) est en un matériau réfractaire conducteur électrique à base de nitrure,
ledit dispositif électro-acoustique étant un filtre à ondes acoustiques de volume guidées sur un réflecteur de Bragg, comprenant, entre le substrat (10) et la première électrode (21), un empilement (50) de couches (51, 52) alternées présentant respectivement des impédances acoustiques fortes et faibles, les couches (52) de faible impédance étant à base de TiN ou de VN, et les couches (51) de forte impédance étant à base de HfN ou de TaN, l'empilement (50) formant un réflecteur de Bragg.

7. Dispositif (1) selon la revendication précédente dans lequel le matériau réfractaire conducteur électrique à base de nitrure est pris parmi les nitrures réfractaires de transition à base d'un métal de transition, par exemple TiN, VN, ZrN, TaN, HfN, NbN, ou leurs alliages.

8. Dispositif (1) selon l'une quelconque des revendications 6 à 7, dans lequel les première et deuxième électrodes (21, 22) sont contactées au niveau d'une face avant (101) du dispositif (1).

9. Dispositif (1) selon l'une quelconque des revendications 6 à 7, dans lequel la première électrode (21) est contactée au niveau d'une face arrière (100) du dispositif (1), et dans lequel la deuxième électrode (22) est contactée au niveau d'une face avant (101) du dispositif (1).

## Patentansprüche

1. Herstellungsverfahren einer elektroakustischen Vorrichtung (1), die eine piezoelektrische Schicht (30) umfasst, wobei die elektroakustische Vorrichtung (1) ein Filter mit geführten Volumenakustikwellen auf Bragg-Reflektor ist, wobei das Verfahren die folgenden Schritte umfasst:
• Bereitstellen eines Substrats (10) auf Siliziumbasis,
• Bilden einer ersten Elektrode (21) auf dem Substrat (10),
• Bilden der piezoelektrischen Schicht (30) auf der ersten Elektrode (21),
• Bilden einer zweite Elektrode (22) auf der piezoelektrischen Schicht (30),
wobei die erste Elektrode (21) aus einem feuerfesten elektrisch leitfähigen Material auf Nitridbasis ausgewählt wird, und wobei das Bilden der piezoelektrische Schicht (30) durch Epitaxie auf der ersten Elektrode (21) eines Materials vom Typ ABO3 umfasst, wobei O Sauerstoff ist, A mindestens ein erstes chemisches Element ausgewählt aus Natrium (Na), Kalium (K), Barium (Ba), Lithium (Li), Blei (Pb) ist, und B mindestens ein zweites chemisches Element ausgewählt aus Zirkonium (Zr), Titan (Ti), Niob (Nb), Tantal (Ta) ist,
wobei das Verfahren außerdem vor dem Bilden der ersten Elektrode (21) ein Bilden einer Stapelung (50) von abwechselnden Schichten (51, 52) umfasst, die jeweils starke und schwache akustische Impedanzen darstellen, wobei die Schichten mit schwacher Impedanz (52) auf TiN oder VN basieren, und die Schichten mit starker Impedanz (51) von HfN oder TaN basieren, wobei die Stapelung (50) einen Bragg-Reflektor bildet.

2. Verfahren nach dem vorstehenden Anspruch, wobei das feuerfeste elektrisch leitfähige Material auf Nitridbasis aus den feuerfesten Übergangsnitriden basierend auf einem Übergangsmetall ausgewählt wird.

3. Verfahren nach dem vorstehenden Anspruch, wobei das feuerfeste elektrisch leitfähige Material auf Nitridbasis aus TiN, VN, ZrN, TaN, HfN, NbN oder ihren Legierungen ausgewählt wird.

4. Verfahren nach einem der vorstehenden Ansprüche, wobei das Bilden der ersten Elektrode (21) und das Bilden der piezoelektrische Schicht (30) durch nacheinander gepulste Laserablation innerhalb desselben Reaktors ohne Entlüften zwischen den Bildungsschritten erfolgen.

5. Verfahren nach einem der vorstehenden Ansprüche, wobei das Substrat (10) auf (111)-orientiertem Silizium basiert, wobei die erste Elektrode (21) auf nach (111)-Titannitrid TiN basiert, und die piezoelektrische Schicht (30) nach (0001) ausgerichtet ist.

6. Elektroakustische Vorrichtung (1), die in Stapelung gemäß einer als vertikal (z) bezeichneten Richtung ein Substrat (10) auf Siliziumbasis, eine erste Elektrode (21) auf dem Substrat (10), eine piezoelektrische Schicht (30) auf der ersten Elektrode (21) umfasst, wobei die piezoelektrische Schicht (30) auf einem Material vom Typ ABO3 basiert, wobei O Sauerstoff ist, A mindestens ein erstes chemisches Element ausgewählt aus Natrium (Na), Kalium (K), Barium (Ba), Lithium (Li), Blei (Pb) ist, und B mindestens ein zweites chemisches Element ausgewählt aus Zirkonium (Zr), Titan (Ti), Niob (Nb), Tantal (Ta) ist, eine zweite Elektrode (22), die auf der piezoelektrische Schicht (30) angeordnet ist, wobei die Vorrichtung (1) **dadurch gekennzeichnet ist, dass** die erste Elektrode (21) aus einem feuerfesten elektrisch leitfähigen Material auf Nitridbasis ist, wobei die elektroakustische Vorrichtung ein Filter mit geführten Volumenakustikwellen auf einem Bragg-Reflektor ist, das zwischen dem Substrat (10) und der ersten Elektrode (21) eine Stapelung (50) aus abwechselnden Schichten (51, 52) umfasst, die jeweils starke und schwache akustische Impedanzen aufweisen, wobei die Schichten (52) mit schwacher Impedanz auf TiN oder VN basieren, und die Schichten (51) mit starker Impedanz auf HfN oder TaN basieren, wobei die Stapelung (50) einen Bragg-Reflektor bildet.

7. Vorrichtung (1) nach dem vorstehenden Anspruch, wobei das feuerfeste elektrisch leitfähige Material auf Nitridbasis aus den feuerfesten Übergangsnitriden auf Basis eines Übergangsmetalls, beispielsweise TiN, VN, ZrN, TaN, HfN, NbN oder ihren Legierungen ausgewählt ist.

8. Vorrichtung (1) nach einem der Ansprüche 6 bis 7, wobei die erste und die zweite Elektrode (21, 22) im Bereich einer Vorderfläche (101) der Vorrichtung (1) kontaktiert sind.

9. Vorrichtung (1) nach einem der Ansprüche 6 bis 7, wobei die erste Elektrode (21) im Bereich einer Rückseite (100) der Vorrichtung (1) kontaktiert ist, und wobei die zweite Elektrode (22) im Bereich einer Vorderseite (101) der Vorrichtung (1) kontaktiert ist.

## Claims

1. Method for producing an electroacoustic device (1) comprising a piezoelectric layer (30), said electroacoustic device (1) being a bulk acoustic wave filter guided on a Bragg reflector, said method comprising the following steps:
• Providing a silicon-based substrate (10),
• Forming a first electrode (21) on the substrate (10),
• Forming the piezoelectric layer (30) on the first electrode (21),
• Forming a second electrode (22) on the piezoelectric layer (30),
wherein the first electrode (21) is chosen made of a nitride-based electrically conductive refractory material, and wherein the formation of the piezoelectric layer (30) is done by epitaxy, on said first electrode (21), of an ABO3-type material, O being oxygen, A being at least one first chemical element taken from among sodium (Na), potassium (K), barium (Ba), lithium (Li), lead (Pb), and B being at least one second chemical element taken from among zirconium (Zr), titanium (Ti), niobium (Nb), tantalum (Ta),
said method further comprising, before formation of the first electrode (21), a formation of a stack (50) of layers (51, 52) alternatively respectively having high and low acoustic impedances, the low impedance layers (52) being TiN- or VN-based, and the high impedance layers (51) being HfN- or TaN-based, the stack (50) forming a Bragg reflector.

2. Method according to the preceding claim, wherein the nitride-based electrically conductive refractory material is taken from among transition refractory nitrides with a basis of a transition metal.

3. Method according to the preceding claim, wherein the nitride-based electrically conductive refractory material is taken from among TiN, VN, ZrN, TaN, HfN, NbN, or their alloys.

4. Method according to any one of the preceding claims, wherein the formation of the first electrode (21) and the formation of the piezoelectric layer (30) are achieved by pulsed laser deposition successively within one same reactor without venting with air between said formations.

5. Method according to any one of the preceding claims, wherein the substrate (10) is silicon-based, oriented along (111), the first electrode (21) is titanium nitride TiN-based oriented along (111), and the piezoelectric layer (30) is oriented along (0001).

6. Electroacoustic device (1) comprising, stacked in a so-called vertical direction (z), a silicon-based substrate (10), a first electrode (21) on said substrate (10), a piezoelectric layer (30) on said first electrode (21), said piezoelectric layer (30) being with the basis of an ABO3-type material, O being oxygen, A being at least one first chemical element taken from among sodium (Na), potassium (K), barium (Ba), lithium (Li), lead (Pb), and B being at least one second chemical element taken from among zirconium (Zr), titanium (Ti), niobium (Nb), tantalum (Ta), a second electrode (22) disposed on the piezoelectric layer (30), the device (1) being **characterised in that** the first electrode (21) is made of a nitride-based electrically conductive refractory material, said electroacoustic device being a bulk acoustic wave filter guided on a Bragg reflector, comprising, between the substrate (10) and the first electrode (21), a stack (50) of layers (51, 52) alternatively having high and low acoustic impedances, the low impedance layers (52) being TiN- or VN-based, and the high impedance layers (51) being HfN- or TaN-based, the stack (50) forming a Bragg reflector.

7. Device (1) according to the preceding claim, wherein the nitride-based electrically conductive refractory material is taken from among transition refractory nitrides with the basis of a transition metal, for example TiN, VN, ZrN, TaN, HfN, NbN, or their alloys.

8. Device (1) according to any one of claims 6 to 7, wherein the first and second electrodes (21, 22) are in contact with a front face (101) of the device (1).

9. Device (1) according to any one of claims 6 to 7, wherein the first electrode (21) is contacted at a rear face (100) of the device (1), and wherein the second electrode (22) is in contact with a front face (101) of the device (1).
